(19) Europäisches Patentamt / European Patent Office / Office européen des brevets

(11) **EP 4 239 345 B1**

(12) **EUROPEAN PATENT SPECIFICATION**

(45) Date of publication and mention of the grant of the patent:
**05.08.2026   Bulletin 2026/32**

(21) Application number: **20959425.8**

(22) Date of filing: **12.11.2020**

(51) International Patent Classification (IPC):
**G01R 31/40** $^{(2020.01)}$      **G01R 31/28** $^{(2006.01)}$
**H02M 1/32** $^{(2007.01)}$      **H02M 5/458** $^{(2006.01)}$

(52) Cooperative Patent Classification (CPC):
**H02M 5/4585; G01R 31/2813; G01R 31/40; H02M 1/32**

(86) International application number:
**PCT/CN2020/128343**

(87) International publication number:
**WO 2022/088265 (05.05.2022 Gazette 2022/18)**

(54) **METHOD AND DEVICE FOR MONITORING ABNORMALITY OF DIRECT-CURRENT CIRCUIT OF CONVERTER**

VERFAHREN UND VORRICHTUNG ZUR ÜBERWACHUNG EINER ANOMALIE EINER GLEICHSTROMSCHALTUNG EINES WANDLERS

PROCÉDÉ ET DISPOSITIF DE SURVEILLANCE D'UNE ANOMALIE D'UN CIRCUIT À COURANT CONTINU D'UN CONVERTISSEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.10.2020   CN 202011183361**

(43) Date of publication of application:
**06.09.2023   Bulletin 2023/36**

(73) Proprietor: **Zhuzhou CRRC Times Electric Co., Ltd.**
**Zhuzhou, Hunan 412001 (CN)**

(72) Inventors:
• **XU, Shaolong**
  **Zhuzhou, Hunan 412001 (CN)**
• **CHEN, Zhibo**
  **Zhuzhou, Hunan 412001 (CN)**
• **LIU, Liangjie**
  **Zhuzhou, Hunan 412001 (CN)**
• **LI, Xueming**
  **Zhuzhou, Hunan 412001 (CN)**

• **ZHANG, Yi**
  **Zhuzhou, Hunan 412001 (CN)**

(74) Representative: **Peters, Sebastian Martinus**
**Octrooibureau Vriesendorp & Gaade B.V.**
**Koninginnegracht 19**
**2514 AB Den Haag (NL)**

(56) References cited:
**CN-A- 105 158 577      CN-A- 106 026 726**
**CN-A- 108 680 818      CN-A- 110 957 762**
**CN-A- 110 957 762      US-A1- 2020 144 810**
**US-A1- 2020 182 934**

• **GOU BIN: "Fault Diagnosis and Fault-Tolerant Control Technology of Railway Electrical Traction Converter", CHINA DOCTORAL DISSERTATIONS FULL-TEXT DATABASE, ENGINEERING SCIENCE AND TECHNOLOGY II, 서울, 15 April 2017 (2017-04-15), 서울, XP055925699**

**Description**

TECHNICAL FIELD

The invention relates to the control field of power electronic converters, in particular relates to the detection of DC circuit parameter deviation in a traction converter.

BACKGROUND

The application of traction converters is very extensive. In related fields such as locomotives and multiple units, their topology is generally an AC-DC-AC type converter, with one end being an AC input and the other end being an AC output, and the intermediate link being a DC circuit, which can achieve bidirectional energy flow; in the fields of power systems, DC transmission, and other fields, the topology is generally an AC-DC type converter, with one end being an AC input and the other end being a DC link, which can also achieve bidirectional energy flow; in the field of urban rail transit, its topology is generally a DC-AC type converter, with one end being a DC input and the other end being an AC output.

These different types of high-power converters are widely used in fields such as traction transmission, DC transmission, electric vehicles, new energy, etc. The main function of these converters is to transmit electrical energy on the power grid, usually converting electrical energy into mechanical energy of the motor. The high-power traction converter provides power to the train and is the "heart" of the train, and its reliability directly determines the reliability of train operation.

During the actual operation of trains, the operating conditions are extremely harsh. As the core equipment for converting electrical energy into mechanical energy, the traction converter also operates under extremely harsh conditions. Its input end is connected to the AC power grid, and the voltage, current, and harmonics from the AC power grid pose a severe challenge to the converter, and the wheel rail connection from the load end also brings a significant power impact to the converter of the locomotive. From the macro level of the locomotive, it appears to be steadily outputting traction power, while at the converter level, real-time changes in current and voltage are constantly occurring. As a buffer for power flow, the DC circuit is crucial for the smoothness of power transmission.

The supporting capacitor of the DC link plays a crucial role in the stable flow of power. In many locomotive traction systems, the intermediate circuit also includes a resonant circuit, which has a good absorption effect on the second harmonic pulsation power input on the AC input side, thereby maintaining the stability of the DC voltage and maintaining a low amplitude pulsation of the DC voltage. After long-term operation, traction converters often encounter problems such as capacitor bulging, capacitor bursting, and capacitor capacitance attenuation, which affect the smooth operation of the DC circuit and traction converter, thereby affecting the smooth operation of the entire locomotive. Sometimes capacitors have certain symptoms before a problem occurs, but due to the lack of effective means for online warning, maintenance and handling are not carried out until the capacitor experiences bulging and bursting, causing adverse effects.

For example, CN 110957762A discloses a three-level traction converter fault classification method and system, and a storage medium, so as to classify five types of common faults in a traction converter.

The present invention provides a monitoring method and device for abnormal DC circuit of the converter, which is capable of monitoring the status of the DC circuit in advance before the problems that occur in the DC circuit have caused adverse effects such as capacitor bulging and bursting, and provide timely warning to prevent further expansion of the problems that occur in the DC circuit from causing accidents.

SUMMARY OF THE INVENTION

A brief overview of one or more aspects is given below to provide a basic understanding of these aspects. This overview is not an exhaustive overview of all aspects envisaged, nor is it intended to identify the key or decisive elements in all aspects nor attempt to define the scope of any or all aspects. Its only purpose is to present some concepts of one or more aspects in a simplified form so as to give a more detailed description of the order later.

As described above, in order to monitor the status of the DC circuit in advance before any problems that may occur in the DC circuit have caused adverse effects such as capacitor bulging and bursting, and provide timely warnings, in order to prevent further expansion of the problems that occur in the DC circuit from causing accidents, the invention provides a monitoring method for abnormal DC circuit of a converter, comprising:

determining the theoretical value of the total impedance of the DC circuit mentioned above;
determining the input current, output current, and actual voltage of the DC circuit mentioned above at the current moment;
calculating the theoretical value of the specific sub-frequency domain component of the DC voltage at the current moment based on the current difference between the input current and output current mentioned above and the theoretical value of the total impedance mentioned above;

calculating the actual value of the specific sub-frequency domain component of the DC voltage based on the actual voltage mentioned above; and

determining whether the DC circuit mentioned above is abnormal based on the theoretical value of the specific sub-frequency domain component of the DC voltage mentioned above and the actual value mentioned above.

In one embodiment of the monitoring method mentioned above, optionally, in response to a rectifier is provided at the front end of the DC circuit mentioned above, to determine the input current mentioned above further comprises:

collecting the AC input current of the rectifier mentioned above;

obtaining the switching functions of each switch in the rectifier mentioned above; and

calculating the input current mentioned above based on the AC input current mentioned above and the switching functions of each switch in the rectifier mentioned above.

In one embodiment of the monitoring method mentioned above, optionally, in response to the DC circuit mentioned above is the input terminal of the converter mentioned above, to determine the input current mentioned above further comprises:

collecting the DC current flowing into the DC circuit mentioned above as the input current mentioned above.

In one embodiment of the monitoring method mentioned above, optionally, in response to an inverter is provided at the back end of the DC circuit mentioned above, to determine the output current mentioned above further comprises:

collecting the AC output current of the inverter mentioned above;

obtaining the switching functions of each switch in the inverter mentioned above; and

calculating the output current mentioned above based on the AC output current mentioned above and the switching functions of each switch in the inverter mentioned above.

In one embodiment of the monitoring method mentioned above, optionally, in response to the DC circuit mentioned above is the output terminal of the converter mentioned above, to determine the output current mentioned above further comprises:

determining that the output current mentioned above is zero.

In one embodiment of the monitoring method mentioned above, optionally, the calculation of the theoretical value mentioned above further comprises:

using the universal fast Fourier algorithm to extract specific sub-frequency domain component of the current difference mentioned above; and

calculating the theoretical value mentioned above based on the specific sub-frequency domain component and the theoretical value of the total impedance mentioned above.

In one embodiment of the monitoring method mentioned above, optionally, the calculation of the actual value mentioned above further comprises:

using the Fourier algorithm to extract specific sub-frequency domain component of the actual voltage mentioned above.

In one embodiment of the monitoring method mentioned above, optionally, the specific sub-frequency domain component mentioned above is the secondary frequency domain component.

In one embodiment of the monitoring method mentioned above, optionally, judging whether the DC circuit mentioned above is abnormal further comprises:

in response to the difference between the theoretical value mentioned above and the actual value mentioned above is greater than the preset threshold, or in response to the ratio between the theoretical value mentioned above and the actual value mentioned above exceeds the preset range, it is determined that the DC circuit mentioned above is abnormal.

In one embodiment of the monitoring method mentioned above, optionally, the monitoring method mentioned above also comprises:

performing low-pass filtering on the theoretical value mentioned above and the actual value mentioned above; wherein

the determination of whether the DC circuit mentioned above is abnormal further comprises:

determining whether the DC circuit mentioned above is abnormal based on the theoretical value mentioned above and the actual value mentioned above processed by low-pass filtering.

In one embodiment of the monitoring method mentioned above, optionally, the monitoring method mentioned above also comprises:

in response to determining the abnormality of the DC circuit mentioned above, an alarm signal is output to indicate that the converter mentioned above needs maintenance.

In one embodiment of the monitoring method mentioned above, optionally, the monitoring method mentioned above also comprises:

recording the number of abnormal occurrences of the DC circuit mentioned above; and
in response to the number of abnormal occurrences of the DC circuit mentioned above exceeding the preset threshold value, an alarm signal is output to indicate that the converter mentioned above needs maintenance.

In one embodiment of the monitoring method mentioned above, optionally, the determination of the theoretical value of the total impedance mentioned above further comprises:

determining the topological structure of the DC circuit mentioned above;
obtaining the design impedance values of each element; and
based on the topological structure mentioned above and the design impedance of each element, calculating the theoretical value of the total impedance mentioned above.

The invention also provides a monitoring device for abnormal DC circuit of a converter, comprising: a processor, a memory, and computer instructions being stored in the memory and run on the processor. The processor is configured to perform the steps of the monitoring method described in any of the above embodiments.

The invention also provides a computer-readable storage medium on which computer instructions are stored. The steps of the monitoring method described in any of the above embodiments are implemented when the computer instructions mentioned above are executed by a processor.

According to the monitoring method and device for abnormal DC circuit of the converter provided by the invention, timely warning is given when there is a significant change in DC circuit parameters, especially capacitance value, to prevent the problem from expanding and causing accidents. The invention is suitable for converters with different topology forms, such as AC-DC-AC, AC-DC, and DC-AC, and is widely applied in different fields with wide adaptability. Another advantage of the invention is that the proposed method is easy to implement in engineering and does not require the addition of new sensors. It only improves the intelligence level of the processing method (algorithm) without the need for additional hardware costs, making it valuable for specific engineering implementations.

BRIEF DESCRIPTION OF THE DRAWINGS

After reading the detailed description of the disclosed embodiments in conjunction with the drawings below the above characteristics and advantages of the invention can be better understood. In the drawings, the components are not necessarily drawn to scale, and components with similar related characteristics or features may have the same or similar references.

Figure 1 shows a flowchart of a monitoring method for abnormal DC circuit of a converter provided in one aspect of the invention.
Figure 2 shows a schematic diagram of the circuit topological structure of an AC-DC-AC type converter applicable to the monitoring method provided by the invention.
Figure 3 shows a schematic diagram of any bridge arm triggering pulse $G_i$ in the AC circuit.
Figure 4 shows a structural schematic diagram of a monitoring device for abnormal DC circuit of a converter provided in another aspect of the invention.

REFERENCES

| | |
|---|---|
| $U_N$ | AC side input voltage |
| $I_1$ | AC side input current |
| $U_{d1}$ | DC voltage |
| $U_{d2}$ | half intermediate DC voltage |
| $I_2$ | AC side U-phase output current |
| $I_3$ | AC side V-phase output current |
| $I_4$ | AC side W-phase output current |

| $K_1$ | charging contactor |
|---|---|
| $K_2$ | short circuit contactor |
| $R_1$ | charge resistor |
| $R_2$ | voltage divider resistor |
| $R_3$ | voltage divider resistor |
| $C_d$ | supporting capacitor |
| $C_2$ | resonant capacitor |
| $L_2$ | resonant inductor |
| $T_1$-$T_4$ | switch tube of the rectifier |
| $T_5$-$T_{10}$ | switch tube of the inverter |
| $I_{d1}$ | DC side input current |
| $I_{d2}$ | DC side output current |
| 400 | the monitoring device |
| 410 | the processor |
| 420 | the memory |

DETAILED DESCRIPTION

Provide the following description to enable those skilled in the art to implement and use the invention and incorporate it into specific application backgrounds. Various variants and various uses in different applications will be easily apparent to those skilled in the art. herein.

In the following detailed description, many specific details are elaborated to provide a more thorough understanding of the invention. However, it is evident to those skilled in the art that the practice of the invention does not need to be limited to these specific details. In other words, well-known structures and components are shown in block diagram form without detailed display to avoid blurring the present invention.

Note that when used, the symbols left, right, front, back, top, bottom, forward, reverse, clockwise, and counterclockwise are only used for convenience purposes and do not imply any specific fixed direction. In fact, they are used to reflect the relative positions and/or directions between the various parts of an object. In addition, the terms "first" and "second" are only used to describe the purpose and cannot be understood as indicating or implying relative importance.

Note that when used, further, preferably, furthermore, and more preferably is a simple starting point for elucidating another embodiment based on the aforementioned embodiment. The combination of the further, preferably, furthermore, or more preferably content with the aforementioned embodiment serves as the complete composition of the other embodiment. Another embodiment is composed of several further, preferably, further, or more preferably settings that are capable of being arbitrarily combined after the same embodiment.

The following is a detailed description of the invention in conjunction with the drawings and specific embodiments. Note that the following aspects described in conjunction with the drawings and specific embodiments are only illustrative and should not be construed as limiting the scope of protection of the invention.

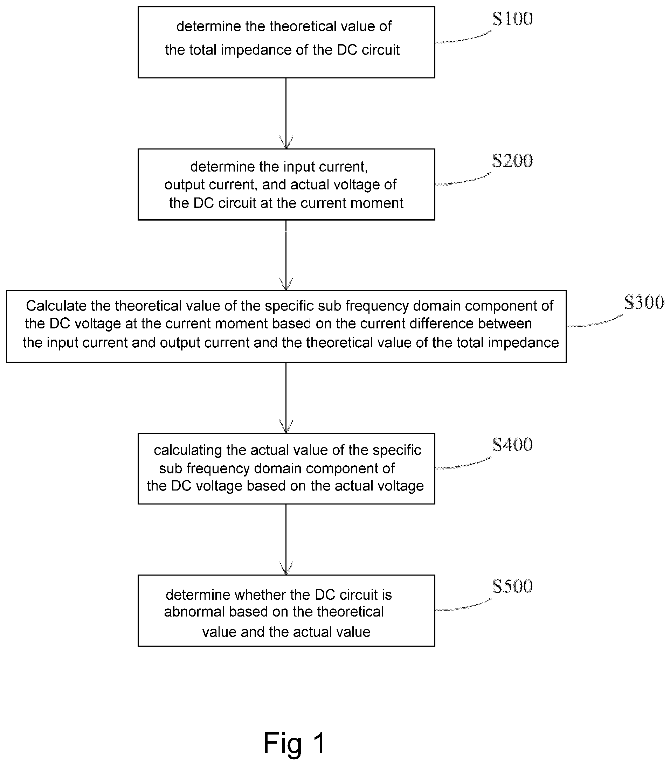

As described above, in order to monitor the status of the DC circuit in advance before any problems that may occur in the DC circuit, such as capacitor bulging or bursting, and provide timely warnings, to prevent further expansion of the problems that may cause accidents, one aspect of the invention provides a monitoring method for abnormal DC circuit of a converter. Please refer to Figure 1, Figure 1 shows a flowchart of an embodiment of the monitoring method mentioned above. As shown in Figure 1, the monitoring method mentioned above comprises: step S100: determining the theoretical value of the total impedance of the DC circuit; step S200: determining the input current, output current, and actual voltage of the DC circuit at the current moment; step S300: calculating the theoretical value of the specific sub-frequency domain component of the DC voltage at the current moment based on the current difference between the input current and output current and the theoretical value of the total impedance; step S400: calculating the actual value of the specific sub-frequency domain component of the DC voltage based on the actual voltage; and step S500: determining whether the DC circuit is abnormal based on the theoretical value and the actual value.

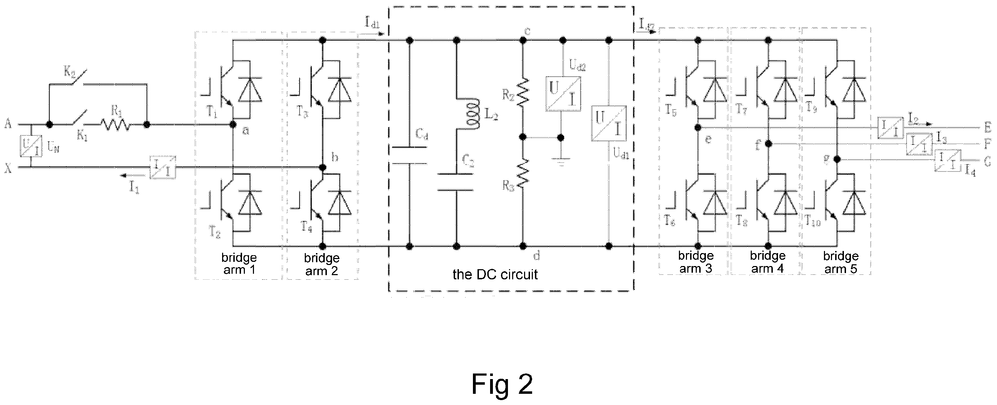

Please understand the monitoring method mentioned above by further combining it with the circuit topological structure of the AC-DC-AC type converter that is applicable to the monitoring method of the invention as shown in Figure 2. Firstly, as shown in Figure 2, the AC-DC-AC type converter comprises the AC input side, DC circuit, and AC output side. The AC input side mentioned above comprises a four-quadrant converter composed of bridge arm 1 and bridge arm 2, and the four-quadrant converter is used as a rectifier. The AC output side mentioned above comprises a traction inverter composed of bridge arm 3, bridge arm 4, and bridge arm 5, which is used as an inverter.

It should be noted that the circuit topological structure of the AC-DC-AC type converter shown in Figure 2 is the most complete schematic of the structure among conventional converters. For AC-DC type converters, their circuit topological structure correspondingly does not include the AC output side of the backend, that is, the DC circuit is the output end of the converter. For DC-AC type converters, their circuit topological structure correspondingly does not include the AC input side of the front end, that is, the DC circuit is the input end of the converter.

Furthermore, for the rectifier and the inverter on the AC side, switch tubes $T_1$ and $T_2$ form bridge arm 1, switch tubes $T_3$ and $T_4$ form bridge arm 2, switch tubes $T_5$ and $T_6$ form bridge arm 3, switch tubes $T_7$ and $T_8$ form bridge arm 4, and switch tubes $T_9$ and $T_{10}$ form bridge arm 5. It can be understood that the above topological structure is a common topological structure in rectifiers and inverters, and the monitoring method provided by the invention is also capable of being applied to other topological structures, such as a topological structure consisting of three switch tubes forming one bridge arm.

Let $G_1 \sim G_5$ respectively represent the triggering pulses of the switch tubes of bridge arm 1 to bridge arm 5 in Figure 2, i.e. the switching function, and the triggering pulses $G_1 \sim G_5$ are respectively 1 or 0. It can be understood that for other topological structures, the switch function $G_i$ corresponding to the topological structure is obtained.

$$G_i = \begin{cases} 1; (the\ upper\ tube\ of\ bridge\ arm\ i\ is\ on, the\ lower\ tube\ is\ off) \\ 0; (the\ lower\ tube\ of\ bridge\ arm\ i\ is\ on, the\ upper\ tube\ is\ off) \end{cases} \qquad (1)$$

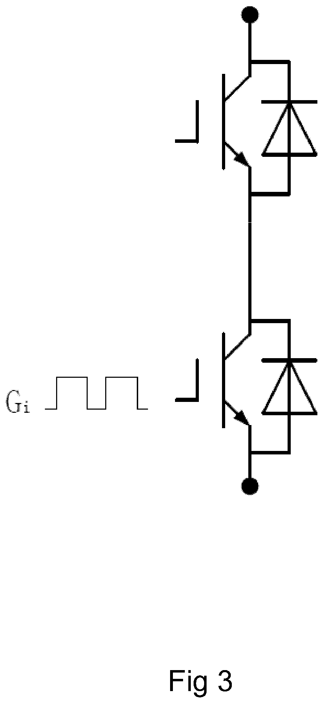

Please combine Figure 3 to understand the pulse triggering schematic of any bridge arm corresponding to the switch function $G_i$ in formula (1).

Furthermore, $U_N$ represents the AC side input voltage; $I_1$ represents the AC side input current; $I_2$ represents the AC side U-phase output current; $I_3$ represents the AC side V-phase output current; $I_4$ represents the AC side W-phase output current. The front end of the converter connected to the power grid also comprises: charge resistor $R_1$, charging contactor $K_1$ and short circuit contactor $K_2$. The $I_1$ - $I_4$ mentioned above are capable of being obtained through current sensor collection, corresponding to step S200. Optionally, the current $I_2$ - $I_4$ of the three-phase inverter are capable of only being collected from any two of them, and the third current is capable of being calculated from the two collected currents. After collecting currents $I_1$ - $I_4$, the output current of the rectifier (DC current) and the input current of the inverter (DC current) are capable of being calculated using the formula (2) listed below.

$$\begin{cases} I_{d1} = I_1 * G_1 - I_1 * G_2 \\ I_{d2} = I_2 * G_3 + I_3 * G_4 + I_4 * G_5 \end{cases} \qquad (2)$$

The DC circuit comprises: supporting capacitor $C_d$, voltage divider resistor $R_2$, voltage divider resistor $R_3$, preferably, in the embodiment shown in Figure 2, the DC circuit also comprises a resonant branch, specifically comprising a resonant capacitor $C_2$ and a resonant inductor $L_2$. $U_{d1}$ is the DC voltage, which is obtained by a voltage sensor collection, corresponding to step S200. $U_{d2}$ is the half intermediate DC voltage. For the DC circuit, the output current $I_{d1}$ of the rectifier is the input current on the DC side, and the input current $I_{d2}$ of the inverter is the output current on the DC side.

For a DC circuit, the difference between its input current $I_{d1}$ and output current $I_{d2}$ is the current flowing into the impedance network of the DC circuit, and the voltage formed by this current on the impedance network of the DC circuit is the DC voltage $U_{d1}$.

Furthermore, as described above, the monitoring method provided by the invention is applicable to various forms of converters. In the AC-DC-AC type converter mentioned above, the output current $I_{d1}$ of the rectifier is the input current on the DC side, and the input current $I_{d2}$ of the inverter is the output current on the DC side. Therefore, the input current $I_{d1}$ and output current $I_{d2}$ of the DC circuit are capable of being calculated using formula 2. For other forms of inverters, it is necessary to further determine the input current $I_{d1}$ and output current $I_{d2}$ of the DC circuit.

Specifically, for the input current $I_{d1}$, the first is to determine whether a rectifier is provided at the front end of the DC circuit. If a rectifier is provided at the front end of the DC circuit, the input current $I_{d1}$ is the output current of the rectifier, which is obtained through formula 2. If there is no rectifier provided at the front end of the DC circuit, a current sensor is needed to collect the DC current flowing into the DC circuit as the input current $I_{d1}$.

For the output current $I_{d2}$, the first is to determine whether an inverter is provided at the back end of the DC circuit. If an inverter is provided at the back end of the DC circuit, the output current $I_{d2}$ is the input current of the inverter, which is obtained through formula **2**. If there is no inverter provided at the back end of the DC circuit, the output current $I_{d2}$ is directly determined to be zero.

By using the method described above for determining the input current $I_{d1}$ and output current $I_{d2}$ of the DC circuit suitable for various converter structures, the input current $I_{d1}$ and output current $I_{d2}$ of the DC circuit are capable of being calculated, and the difference between the input current $I_{d1}$ and output current $I_{d2}$ of the DC circuit is:

$$\Delta I_d = I_{d1} - I_{d2} \qquad (3)$$

For the total impedance value of the DC circuit, when the topological structure of the DC circuit is determined, the initial designed theoretical value $Z_n$ is capable of being calculated based on the topological structure.

For the circuit topological structure of the DC circuit shown in Figure 2, $Z_n$ is capable of being represented by the following formula 4:

$$Z_n = \left( Z_{Cd} \parallel \left( Z_{L2} + Z_{C2} \right) \right) \parallel \left( R_2 + R_3 \right) \qquad (4)$$

It can be seen that using a formula similar to formula 4, the total impedance of the DC circuit is capable of being calculated, corresponding to step S100. If the supporting capacitor, resonant inductor, resonant capacitor, and other stray parameters in the DC circuit are not considered, the total impedance is also capable of being calculated using a formula similar to formula 4. It can be understood that since the theoretical value of the total impedance $Z_n$ of the DC circuit is determined after the topological structure of the DC circuit is determined, that is, the total impedance $Z_n$ is a constant. Therefore, in step S100 above, the theoretical value of the total impedance of the DC circuit is determined by calculating the total impedance $Z_n$ according to formula 4, the theoretical value of the total impedance of the DC circuit is also determined by obtaining the stored pre-calculated total impedance $Z_n$.

At the same time, the execution steps of step S100 and step S200 is capable of being replaced, and the execution sequence of these two steps should not improperly limit the protection scope of the invention.

$\Delta I_d$ is a time-domain component, and specific sub-frequency domain component in $\Delta I_d$ is extracted through the general fast Fourier algorithm. It should be noted that those skilled in the art is capable of using other algorithms to extract specific sub-frequency domain component in $\Delta I_d$. The general fast Fourier algorithm mentioned above is only for illustration and should not improperly limit the protection scope of the invention.

In one embodiment, selecting to extract the secondary frequency domain component $\Delta I_{d2}$ in $\Delta I_d$, it can be understood that the amplitude of the secondary frequency domain component $\Delta I_{d2}$ in $\Delta I_d$ is relatively large, which can make anomaly monitoring more sensitive.

Then, in the frequency domain, the secondary frequency domain component that calculate the DC voltage are:

$$\Delta U_{d2} = \Delta I_{d2} * Z_n \qquad (5)$$

It can be understood that due to the extraction of the secondary frequency domain component of $\Delta I_d$ during the extraction process of $\Delta I_d$, the calculated DC voltage is also the secondary frequency domain component of the DC voltage. In other embodiments, other specific frequency domain components of the DC voltage are capable of being calculated accordingly.

Furthermore, in the frequency domain, it is easy to calculate the amplitude $\Delta U_{d2m}$ of $\Delta U_{d2}$. Therefore, step S300 is already achieved, which calculates the theoretical value of the specific sub-frequency domain component of the DC voltage at the current time based on the current difference between the input current and output current and the theoretical value of the total impedance.

From the above formula and settings, it can be seen that $Z_n$ is the total design impedance of the DC circuit, which was set at the beginning of the converter design. However, due to manufacturing errors or the attenuation of capacitance after long-term operation, the actual value $Z_n^{'}$ of the total impedance of the DC circuit deviates from the design value $Z_n^{'}$.

That is to say, in practical situations, the secondary frequency domain component $\Delta U_{d2}^{'}$ and $Z_n^{'}$ of the actual DC voltage should meet the following conditions:

$$\Delta U_{d2}^{'} = \Delta I_{d2} * Z_n^{'} \qquad (6)$$

That is to say, when the current condition $\Delta I_{d2}$ is determined, the deviation between the actual total impedance and the theoretical total impedance is determined by comparing the actual DC voltage with the theoretical DC voltage, thereby reflecting the abnormal situation of the DC circuit.

In practice, the DC voltage $U_{d1}$ collected in step S200 is subjected to Fourier analysis to extract the secondary component $\Delta U_{d2}^{'}$, corresponding to step S400.

Furthermore, in the frequency domain, the amplitude $\Delta U_{d2m}^{'}$ of $\Delta U_{d2}^{'}$ is easily calculated.

Therefore, by comparing the theoretical value of the DC voltage secondary component calculated in step S300 with the actual value of the DC voltage secondary component calculated in step S400, it is capable of being determined whether the magnitude of the DC voltage secondary pulsation is within a reasonable fluctuation range.

Set a reasonable threshold value $\Delta U_{dg}$, to determine whether the secondary pulsation of the DC voltage exceeds the reasonable fluctuation range by

$$\left| \Delta U_{d2m} - \Delta U_{d2m}^{'} \right| > \Delta U_{dg} \qquad \text{(formula 7)}.$$

Furthermore, the threshold value $\Delta U_{dg}$ mentioned above is capable of being a preset constant threshold, and in another embodiment, the threshold value $\Delta U_{dg}$ mentioned above is also capable of being a variable value based on the variation of $\Delta U_{d2m}$. If it is a variable value, it represents whether the ratio between the theoretical value and the actual value exceeds the preset range. It can be understood that those skilled in this field set different comparison methods based on actual situations to determine the deviation between the theoretical value and the actual value of the secondary component of the DC voltage, and then reflect the deviation between the theoretical value and the actual value of the total impedance of the DC circuit, thereby characterizing whether the DC circuit is abnormal.

It should be noted that in the invention, due to only monitoring the secondary pulsation (or other specific pulsations) in the DC voltage, the high-frequency harmonics caused by the switch of the rectifier or the inverter is not capable of having a significant impact on the monitoring results, and is capable of being ignored in the method of the invention. Therefore, the monitoring results reliably monitor the abnormal parameters of the DC circuit.

In another preferred embodiment, after calculating the theoretical value $\Delta U_{d2m}$ and the actual value $\Delta U_{d2m}^{'}$ of the secondary component of the DC voltage, the monitoring method provided by the invention also comprises performing low-pass filtering on the theoretical value $\Delta U_{d2m}$ and the actual value $\Delta U_{d2m}^{'}$ mentioned above, thereby reducing the noise interference between the theoretical value $\Delta U_{d2m}$ and the actual value $\Delta U_{d2m}^{'}$.

In the embodiment of low-pass filtering on the theoretical value $\Delta U_{d2m}$ and the actual value $\Delta U_{d2m}^{'}$ mentioned above, since noise interference has been eliminated, once the abnormal DC circuit parameters are determined through the theoretical value $\Delta U_{d2m}$ and the actual value $\Delta U_{d2m}^{'}$ after low-pass filtering, the judgment is considered reliable. Therefore, it is preferred that the monitoring method also comprises: in response to determining the abnormality of the DC circuit, an alarm signal is output to indicate that the converter needs maintenance.

In another preferred embodiment, also set a counter, corresponding to a count value of M. As long as the relationship between the theoretical value $\Delta U_{d2m}$ and the actual value $\Delta U_{d2m}^{'}$ meets Formula 7, M is increased by 1. By setting the threshold value N for the count value, when M>N, the above comparison results are considered reliable. If the parameters of the DC circuit are abnormal, an alarm signal is output to indicate that the converter needs maintenance.

It can be understood that those skilled in this field determine whether the comparison results between the theoretical value $\Delta U_{d2m}$ and the actual value $\Delta U_{d2m}^{'}$ are reliable by setting various judgment conditions. For example, they also output alarm signals to indicate that the converter needs maintenance by determining whether the quantity that meets Formula 7 determined within a certain period of time exceeds a certain range.

At this point, the specific implementation of the monitoring method for abnormal DC circuit of a converter provided by the invention has been described. Due to changes in parameters such as supporting capacitors, resonant capacitors, and resonant inductors, the resonance point of the DC circuit will shift, which will cause the pulsating power from the single-phase traction power supply network to not be well absorbed, resulting in significant direct current voltage fluctuations on the DC circuit. The monitoring method provided by the invention monitors the pulsation of DC voltage in real time under the normal working state of the converter, and effectively distinguishes between normal and abnormal pulsation of DC voltage. When obvious abnormalities are found in the DC circuit parameters, timely warning is given, and after-sales service personnel are prompted to carry out maintenance and troubleshooting. It can effectively avoid serious faults in the locomotive and is a method with engineering application value.

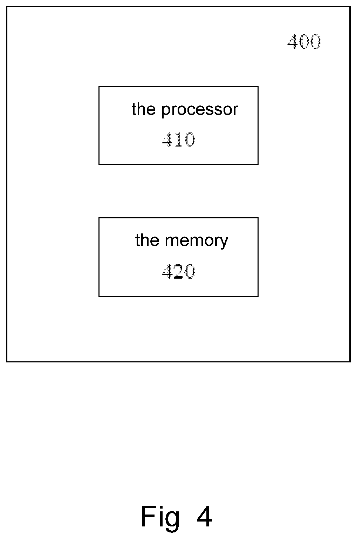

Another aspect of the invention also provides a monitoring device for abnormal DC circuit of a converter. Please refer to Figure 4, which shows a schematic diagram of the monitoring device for abnormal DC circuit of a converter provided by another aspect of the invention. As shown in Figure 4, another aspect of the invention provides a monitoring device 400 for abnormal DC circuit of the converter, which comprises a processor 410 and a memory 420. The processor 410 of the monitoring device 400 for abnormal DC circuit of the converter mentioned above achieves the monitoring method for abnormal DC circuit of the converter described above when executing computer instructions stored on the memory 420. For details, please refer to the description of the monitoring method for abnormal DC circuit of a converter mentioned above, which will not be repeated here.

Another aspect of the invention also provides a computer storage medium on which computer instructions are stored. When computer instructions are executed by the processor to realize the steps of the monitoring method for abnormal DC circuit of a converter as described above. For details, please refer to the description of the monitoring method for abnormal DC circuit of a converter mentioned above, which will not be repeated here.

According to the monitoring method and device for abnormal DC circuit of the converter provided by the invention, timely warning is given when there is a significant change in DC circuit parameters, especially capacitance value, to prevent the problem from expanding and causing accidents. The invention is suitable for converters with different topology forms, such as AC-DC-AC, AC-DC, and DC-AC, and is widely applied in different fields with wide adaptability. Another advantage of the invention is that the proposed method is easy to implement in engineering and does not require the addition of new sensors. It only improves the intelligence level of the processing method (algorithm) without the need for additional hardware costs, making it valuable for specific engineering implementations.

Those of skill in the art would understand that information and signals may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

Those of skill would further appreciate that the various illustrative logical blocks, modules, circuits, and algorithm steps described in connection with the embodiments disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present invention.

The various illustrative logical blocks, modules, and circuits described in connection with the embodiments disclosed herein may be implemented or performed with a general purpose processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

The steps of a method or algorithm described in connection with the embodiments disclosed herein may be embodied directly in hardware, in a software module executed by a processor, or in a combination of the two. A software module may reside in RAM memory, flash memory, ROM memory, EPROM memory, EEPROM memory, registers, hard disk, a removable disk, a CD-ROM, or any other form of storage medium known in the art. An exemplary storage medium is coupled to the processor such the processor can read information from, and write information to, the storage medium. In the alternative, the storage medium may be integral to the processor. The processor and the storage medium may reside in an ASIC. The ASIC may reside in a user terminal. In the alternative, the processor and the storage medium may reside as discrete components in a user terminal.

In one or more exemplary embodiments, the functions described may be implemented in hardware, software, firmware, or any combination thereof. If implemented in software as a computer program product, the functions may be stored on or transmitted over as one or more instructions or code on a computer-readable medium. Computer-readable media includes both computer storage media and communication media including any medium that facilitates transfer of a computer program from one place to another. A storage media may be any available media that can be accessed by a computer. By way of example, and not limitation, such computer-readable media can comprise RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Also, any connection is properly termed a computer-readable medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. Disk and disc, as used herein, includes compact disc (CD), laser disc, optical disc, digital versatile disc (DVD), floppy disk and blue-ray disc where disks usually reproduce data magnetically, while discs reproduce data optically with lasers. Combinations of the above should also be included within the scope of computer-readable media.

The previous description of the disclosed embodiments is provided to enable any person skilled in the art to make or use the present invention. Various modifications to these embodiments will be readily apparent to those skilled in the art, and the generic principles defined herein may be applied to other embodiments without departing from the scope of the invention as defined in the claims. Thus, the present invention is not intended to be limited to the embodiments shown herein.

**Claims**

1.  A monitoring method for abnormal DC circuit of a converter, comprising:

    (S100) determining a theoretical value of a total impedance of the DC circuit;
    (S200) determining an input current, an output current, and an actual voltage of the DC circuit at the current moment;
    (S300) calculating a theoretical value of a specific sub-frequency domain component of the DC voltage at the current moment based on the current difference between the input current and output current and the theoretical value of the total impedance;
    (S400) calculating the actual value of the specific-sub frequency domain component of the DC voltage based on the actual voltage; and
    (S500) determining whether the DC circuit is abnormal based on the theoretical value of the specific sub-frequency domain component of the DC voltage and the actual value.

2.  The monitoring method of claim 1, wherein in response to that a rectifier is provided at the front end of the DC circuit, the determining the input current further comprises:

    collecting an AC input current of the rectifier;
    obtaining a switching function of each switch in the rectifier; and
    calculating the input current based on the AC input current and the switching function of each switch in the rectifier.

3.  The monitoring method of claim 1, wherein in response to that the DC circuit is an input terminal of the converter, the determining the input current further comprises:
    collecting the DC current flowing into the DC circuit as the input current.

4.  The monitoring method of claim 1, wherein in response to that an inverter is provided at the back end of the DC circuit, the determining the output current further comprises:

    collecting an AC output current of the inverter;
    obtaining a switching function of each switch in the inverter; and
    calculating the output current based on the AC output current and the switching function of each switch in the inverter.

5.  The monitoring method of claim 1, wherein in response to the DC circuit being the output terminal of the converter, the determining the output current further comprises:
    determining that the output current is zero.

6.  The monitoring method of claim 1, wherein the calculating the theoretical value further comprises:

    using a universal fast Fourier algorithm to extract specific sub-frequency domain component of the current difference; and
    calculating the theoretical value based on the specific sub-frequency domain component and the theoretical value of the total impedance.

7.  The monitoring method of claim 1, wherein the calculating the actual value further comprises:
    using the Fourier algorithm to extract specific-sub frequency domain component of the actual voltage.

8.  The monitoring method of claim 6 or claim 7, wherein the specific sub-frequency domain component is a secondary frequency domain component.

9.  The monitoring method of claim 1, wherein the determining whether the DC circuit is abnormal further comprises:
    in response to that the difference between the theoretical value and the actual value is greater than a preset threshold, or in response to that a ratio between the theoretical value and the actual value exceeds a preset range, it is determined that the DC circuit is abnormal.

10. The monitoring method of claim 9, wherein the monitoring method further comprises:

performing low-pass filtering on the theoretical value and the actual value; wherein
the determining whether the DC circuit is abnormal further comprises:
determining whether the DC circuit is abnormal based on the theoretical value and the actual value processed by low-pass filtering.

**11.** The monitoring method of claim 10, wherein the monitoring method further comprises:
in response to determining that the DC circuit is abnormal, an alarm signal is output to indicate that the converter needs maintenance.

**12.** The monitoring method of claim 9, wherein the monitoring method further comprises:

recording a number of abnormal occurrences of the DC circuit; and
in response to the number of abnormal occurrences of the DC circuit exceeding a preset threshold value, an alarm signal is output to indicate that the converter needs maintenance.

**13.** The monitoring method of claim 1, wherein the determining the theoretical value of the total impedance further comprises:

determining a topological structure of the DC circuit;
obtaining a design impedance value of each element; and
based on the topological structure and the design impedance of each element, calculating the theoretical value of the total impedance.

**14.** A monitoring device for abnormal DC circuit of a converter, comprising: a processor (410), a memory (420), and computer instructions being stored in the memory and run on the processor, the processor is configured to perform the steps of the monitoring method of any of the claims 1 - 13.

**15.** A computer-readable storage medium, having computer instructions stored thereon, wherein the monitoring method of any of claims 1 - 13 is implemented when the computer instructions are executed by a processor.


**Patentansprüche**

**1.** Verfahren zum Überwachen auf eine anomale Gleichstromschaltung eines Wandlers, das aufweist:

(S100) Bestimmen eines theoretischen Werts einer Gesamtimpedanz der Gleichstromschaltung;
(S200) Bestimmen eines Eingangsstroms, eines Ausgangsstroms und einer tatsächlichen Spannung der Gleichstromschaltung zum aktuellen Zeitpunkt;
(S300) Berechnen eines theoretischen Werts einer spezifischen Subfrequenzbereichskomponente der Gleichspannung zum aktuellen Zeitpunkt basierend auf der Stromdifferenz zwischen dem Eingangsstrom und dem Ausgangsstrom und des theoretischen Werts der Gesamtimpedanz;
(S400) Berechnen des tatsächlichen Werts der spezifischen Subfrequenzbereichskomponente der Gleichspannung basierend auf der tatsächlichen Spannung; und
(S500) Bestimmen, ob die Gleichstromschaltung anomal ist, basierend auf dem theoretischen Wert der spezifischen Subfrequenzbereichskomponente der Gleichspannung und dem tatsächlichen Wert.

**2.** Überwachungsverfahren nach Anspruch 1, wobei als Reaktion darauf, dass ein Gleichrichter am Eingang der Gleichstromschaltung vorgesehen ist, das Bestimmen des Eingangsstroms ferner aufweist:

Erfassen eines Eingangswechselstroms des Gleichrichters;
Erhalten einer Schaltfunktion jedes Schalters im Gleichrichter; und
Berechnen des Eingangsstroms basierend auf dem Eingangswechselstrom und der Schaltfunktion jedes Schalters im Gleichrichter.

**3.** Überwachungsverfahren nach Anspruch 1, wobei als Reaktion darauf, dass die Gleichstromschaltung ein Eingangsanschluss des Wandlers ist, das Bestimmen des Eingangsstroms ferner aufweist:
Erfassen des in den Gleichstromschaltung fließenden Gleichstroms als Eingangsstrom.

4. Überwachungsverfahren nach Anspruch 1, wobei als Reaktion darauf, dass am Back-end der Gleichstromschaltung ein Wechselrichter vorgesehen ist, das Bestimmen des Ausgangsstroms ferner aufweist:

Erfassen eines Ausgangswechselstroms des Wechselrichters;
Erhalten einer Schaltfunktion jedes Schalters im Wechselrichter; und
Berechnen des Ausgangsstroms basierend auf dem Ausgangswechselstrom und der Schaltfunktion jedes Schalters im Wechselrichter.

5. Überwachungsverfahren nach Anspruch 1, wobei als Reaktion darauf, dass die Gleichstromschaltung der Ausgangsanschluss des Wandlers ist, das Bestimmen des Ausgangsstroms ferner aufweist:
Feststellen, dass der Ausgangsstrom null ist.

6. Überwachungsverfahren nach Anspruch 1, wobei das Berechnen des theoretischen Werts ferner aufweist:

Verwenden eines universellen schnellen Fourier-Algorithmus, um eine spezifische Subfrequenzbereichskomponente der Stromdifferenz zu extrahieren; und
Berechnen des theoretischen Werts basierend auf der spezifischen Subfrequenzbereichskomponente und dem theoretischen Wert der Gesamtimpedanz.

7. Überwachungsverfahren nach Anspruch 1, wobei das Berechnen des tatsächlichen Werts ferner aufweist:
Verwenden des Fourier-Algorithmus, um eine spezifische Subfrequenzbereichskomponente der tatsächlichen Spannung zu extrahieren.

8. Überwachungsverfahren nach Anspruch 6 oder Anspruch 7, wobei die spezifische Subfrequenzbereichskomponente eine Sekundärfrequenzbereichskomponente ist.

9. Überwachungsverfahren nach Anspruch 1, wobei das Bestimmen, ob die Gleichstromschaltung anomal ist, ferner aufweist:
als Reaktion darauf, dass die Differenz zwischen dem theoretischen Wert und dem tatsächlichen Wert größer als ein voreingestellter Schwellenwert ist, oder als Reaktion darauf, dass ein Verhältnis zwischen dem theoretischen Wert und dem tatsächlichen Wert einen voreingestellten Bereich überschreitet, wird festgestellt, dass die Gleichstromschaltung anomal ist.

10. Überwachungsverfahren nach Anspruch 9, wobei das Überwachungsverfahren ferner aufweist:

Durchführen einer Tiefpassfilterung am theoretischen Wert und am tatsächlichen Wert; wobei
das Bestimmen, ob die Gleichstromschaltung anomal ist, ferner aufweist:
Bestimmen, ob die Gleichstromschaltung anomal ist, basierend auf dem theoretischen Wert und dem tatsächlichen Wert, die durch Tiefpassfilterung verarbeitet wurden.

11. Überwachungsverfahren nach Anspruch 10, wobei das Überwachungsverfahren ferner aufweist:
als Reaktion auf das Bestimmen, dass die Gleichstromschaltung anomal ist, wird ein Alarmsignal ausgegeben, um anzuzeigen, dass der Wandler gewartet werden muss.

12. Überwachungsverfahren nach Anspruch 9, wobei das Überwachungsverfahren ferner aufweist:

das Erfassen einer Anzahl von anomalen Ereignissen der Gleichstromschaltung; und
als Reaktion darauf, dass die Anzahl der anomalen Ereignisse der Gleichstromschaltung einen voreingestellten Schwellenwert überschreitet, wird ein Alarmsignal ausgegeben, um anzuzeigen, dass der Wandler gewartet werden muss.

13. Überwachungsverfahren nach Anspruch 1, wobei das Bestimmen des theoretischen Werts der Gesamtimpedanz ferner aufweist:

Bestimmen einer topologischen Struktur der Gleichstromschaltung;
Bestimmen eines Auslegungsimpedanzwerts jedes Elements; und
basierend auf der topologischen Struktur und der Auslegungsimpedanz jedes Elements, Berechnen des theoretischen Werts der Gesamtimpedanz.

**14.** Vorrichtung zur Überwachung auf eine anomale Gleichstromschaltung eines Wandlers, die aufweist: einen Prozessor (410), einen Speicher (420) und Computerbefehle, die im Speicher gespeichert sind und auf dem Prozessor ausgeführt werden, wobei der Prozessor konfiguriert ist, die Schritte des Überwachungsverfahrens nach einem der Ansprüche 1 bis 13 auszuführen.

**15.** Computerlesbares Speichermedium, auf dem Computerbefehle gespeichert sind, wobei das Überwachungsverfahren gemäß einem der Ansprüche 1 bis 13 implementiert wird, wenn die Computerbefehle von einem Prozessor ausgeführt werden.

**Revendications**

**1.** Procédé de surveillance pour un circuit à courant continu, CC, anormal d'un convertisseur, comprenant:

(S100) déterminer une valeur théorique d'une impédance totale du circuit CC;
(S200) déterminer un courant d'entrée, un courant de sortie et une tension réelle du circuit CC à l'instant présent;
(S300) calculer une valeur théorique d'une composante de sous-domaine de fréquence spécifique de la tension CC à l'instant présent sur la base de la différence de courant entre le courant d'entrée et le courant de sortie et de la valeur théorique de l'impédance totale;
(S400) calculer la valeur réelle de la composante de sous-domaine de fréquence spécifique de la tension CC sur la base de la tension réelle; et
(S500) déterminer si le circuit CC est ou non anormal sur la base de la valeur théorique de la composante de sous-domaine de fréquence spécifique de la tension CC et de la valeur réelle.

**2.** Procédé de surveillance selon la revendication 1, dans lequel, en réponse au fait qu'un redresseur est prévu à l'extrémité avant du circuit CC, la détermination du courant d'entrée comprend en outre:

collecter un courant d'entrée alternatif, CA, du redresseur;
obtenir une fonction de commutation de chaque commutateur dans le redresseur; et
calculer le courant d'entrée sur la base du courant d'entrée CA et de la fonction de commutation de chaque commutateur dans le redresseur.

**3.** Procédé de surveillance selon la revendication 1, dans lequel, en réponse au fait que le circuit CC est une borne d'entrée du convertisseur, la détermination du courant d'entrée comprend en outre:
collecter le courant CC circulant dans le circuit CC en tant que courant d'entrée.

**4.** Procédé de surveillance selon la revendication 1, dans lequel, en réponse au fait qu'un onduleur est prévu à l'extrémité arrière du circuit CC, la détermination du courant de sortie comprend en outre:

collecter un courant de sortie CA de l'onduleur;
obtenir une fonction de commutation de chaque commutateur dans l'onduleur; et
calculer le courant de sortie sur la base du courant de sortie CA et de la fonction de commutation de chaque commutateur dans l'onduleur.

**5.** Procédé de surveillance selon la revendication 1, dans lequel, en réponse au fait que le circuit CC est la borne de sortie du convertisseur, la détermination du courant de sortie comprend en outre:
déterminer que le courant de sortie est nul.

**6.** Procédé de surveillance selon la revendication 1, dans lequel le calcul de la valeur théorique comprend en outre:

utiliser un algorithme de Fourier rapide universel pour extraire une composante de sous-domaine de fréquence spécifique de la différence de courant; et
calculer la valeur théorique sur la base de la composante de sous-domaine de fréquence spécifique et de la valeur théorique de l'impédance totale.

**7.** Procédé de surveillance selon la revendication 1, dans lequel le calcul de la valeur réelle comprend en outre:
utiliser l'algorithme de Fourier pour extraire une composante du sous-domaine de fréquence spécifique de la tension réelle.

8. Procédé de surveillance selon la revendication 6 ou la revendication 7, dans lequel la composante de sous-domaine de fréquence spécifique est une composante de domaine de fréquence secondaire.

9. Procédé de surveillance selon la revendication 1, dans lequel la détermination du point de savoir si le circuit CC est ou non anormal comprend en outre:
en réponse au fait que la différence entre la valeur théorique et la valeur réelle est supérieure à un seuil prédéfini, ou en réponse au fait qu'un rapport entre la valeur théorique et la valeur réelle dépasse une plage prédéfinie, il est déterminé que le circuit CC est anormal.

10. Procédé de surveillance selon la revendication 9, dans lequel le procédé de surveillance comprend en outre:

effectuer un filtrage passe-bas sur la valeur théorique et la valeur réelle ; dans lequel
la détermination du point de savoir si le circuit CC est ou non anormal comprend en outre :
déterminer si le circuit CC est ou non anormal sur la base de la valeur théorique et de la valeur réelle traitées par filtrage passe-bas.

11. Procédé de surveillance selon la revendication 10, dans lequel le procédé de surveillance comprend en outre:
en réponse à la détermination du fait que le circuit CC est anormal, un signal d'alarme est délivré pour indiquer que le convertisseur nécessite une maintenance.

12. Procédé de surveillance selon la revendication 9, dans lequel le procédé de surveillance comprend en outre:

enregistrer un nombre d'occurrences anormales du circuit CC; et
en réponse au fait que le nombre d'occurrences anormales du circuit CC dépasse une valeur de seuil prédéfinie, un signal d'alarme est délivré pour indiquer que le convertisseur nécessite une maintenance.

13. Procédé de surveillance selon la revendication 1, dans lequel la détermination de la valeur théorique de l'impédance totale comprend en outre:

déterminer une structure topologique du circuit CC;
obtenir une valeur d'impédance de conception de chaque élément; et
sur la base de la structure topologique et de l'impédance de conception de chaque élément, calculer la valeur théorique de l'impédance totale.

14. Dispositif de surveillance pour un circuit CC anormal d'un convertisseur, comprenant: un processeur (410), une mémoire (420) et des instructions informatiques qui sont stockées dans la mémoire et exécutées sur le processeur, le processeur étant configuré pour effectuer les étapes du procédé de surveillance selon l'une quelconque des revendications 1 à 13.

15. Support de stockage lisible par ordinateur, sur lequel sont stockées des instructions informatiques, dans lequel le procédé de surveillance selon l'une quelconque des revendications 1 à 13 est mis en œuvre lorsque les instructions informatiques sont exécutées par un processeur.

```
┌─────────────────────────────────────┐
│   determine the theoretical value of │  ⟍ S100
│   the total impedance of the DC circuit │
└─────────────────────────────────────┘
                  │
                  ▽
┌─────────────────────────────────────┐
│       determine the input current,   │  ⟍ S200
│   output current, and actual voltage of │
│   the DC circuit at the current moment │
└─────────────────────────────────────┘
                  │
                  ▽
┌───────────────────────────────────────────────────────────────────┐
│ Calculate the theoretical value of the specific sub frequency domain component of │  ⟍ S300
│ the DC voltage at the current moment based on the current difference between │
│ the input current and output current and the theoretical value of the total impedance │
└───────────────────────────────────────────────────────────────────┘
                  │
                  ▽
┌─────────────────────────────────────┐
│   calculating the actual value of the specific │  ⟍ S400
│       sub frequency domain component of │
│   the DC voltage based on the actual voltage │
└─────────────────────────────────────┘
                  │
                  ▽
┌─────────────────────────────────────┐
│       determine whether the DC circuit is │  ⟍ S500
│       abnormal based on the theoretical │
│           value and the actual value │
└─────────────────────────────────────┘
```

# Fig 1

Fig 2

Fig 3

400

the processor

410

the memory

420

Fig 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 110957762 A